# EUROPEAN PATENT APPLICATION

(11) **EP 4 414 783 A1**
(43) Date of publication of application: **14.08.2024**
(21) Application number: 23155835.4
(22) Date of filing: 09.02.2023
(51) Int. Cl.: G03F 7/00, G01B 11/02

(54) **METHOD FOR NONLINEAR OPTICAL MEASUREMENT OF PARAMETER**

(71) Applicant: Stichting Nederlandse Wetenschappelijk Onderzoek Instituten, 3526 KV Utrecht (NL); Stichting VU, 1081 HV Amsterdam (NL); Universiteit van Amsterdam, 1012 WX Amsterdam (NL); ASML Netherlands B.V., 5500 AH Veldhoven (NL)
(72) Inventor: BIJLOO, Falco, 3526 KV Utrecht (NL); KOENDERINK, Albert, Femius, 3526 KV Utrecht (NL); KRAUS, Peter, Michael, 1081 HV Amsterdam (NL); DEN BOEF, Arie, Jeffrey, 5500 AH Veldhoven (NL)
(74) Representative: ASML Netherlands B.V.

(57) **Abstract**

A method for measuring a parameter of a substrate, comprises receiving pump radiation. A metrology target on the substrate is irradiated with the received radiation, thereby generating, through resonances, harmonic generated radiation. Using a metrology sensor, intensities are detected of at least two opposite radiation orders of the harmonic generated radiation diffracted by the metrology target. The parameter of the substrate is determined based on the intensities of the at least two opposite radiation orders and a peak wavelength of the harmonic generated radiation.

## Description

### FIELD

The present invention relates to methods and apparatus usable, for example, in the manufacture of devices by lithographic techniques, and to methods of manufacturing devices using lithographic techniques. The invention relates more particularly to metrology target design, metrology methods, metrology sensors and lithography apparatuses having such a metrology sensor, and more particularly still to illumination-detection arrangements for such metrology sensors.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In lithographic processes, it is desirable to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-IR wave range, which requires the pitch of the grating to be much coarser than the actual product structures whose properties are actually of interest. Such product features could be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure. It is an objective of the current disclosure to provide improved methods and systems of measurement for lithographically patterned structures.

### SUMMARY OF THE INVENTION

According to a first aspect of the current disclosure, there is provided a method for measuring a parameter of a substrate. The method comprises receiving pump radiation. A metrology target on the substrate is irradiated with the received radiation, thereby generating, through resonances, harmonic generated radiation. Using a metrology sensor, intensities are detected of at least two opposite radiation orders of the harmonic generated radiation diffracted by the metrology target. The parameter of the substrate is determined based on the intensities of the at least two opposite radiation orders and a peak wavelength of the harmonic generated radiation.

Optionally, the metrology target may comprises a meta-structure.

Optionally, the meta-structure may comprise a plurality of meta-atoms with a periodicity that is larger than the wavelength of the harmonic generated radiation. Each meta-atom may comprise one or more features with a first dimension that is smaller than at least one wavelength of the harmonic generated radiation.

Optionally, the meta-structure may comprise a grating, the grating comprising alternating grating lines having different widths.

Optionally, the alternating grating lines may comprise a first grating line having a first width and a second grating line having a second width. The second width may be smaller than the first width.

Optionally, the opposite radiation orders may comprise positive and negative first diffraction orders.

Optionally, the harmonic generated radiation may comprise third harmonic radiation orders.

Optionally, intensities of multiple harmonic generated radiation orders may be measured.

Optionally, the multiple harmonic generated radiation orders may comprise at least two of the third, fifth, and seventh harmonic radiation orders.

Optionally, generating the harmonic generated radiation may comprise a quasi-bound state in the continuum resonance.

Optionally, the parameter may comprise critical dimension.

Optionally, the method may further comprise determining an asymmetry parameter based on a difference in the intensities of the at least two opposite radiation orders. A geometrical parameter may be determined based on the asymmetry parameter and the absolute size. The parameter may be determined based on the geometrical parameter.

Optionally, the pump radiation may comprise radiation with a wavelength in a range from 400 nm to 2500 nm.

Optionally, the harmonic generated radiation may comprise radiation with a wavelength in a range from 100 nm to 700 nm.

According to another aspect of the current disclosure there is provided an apparatus for measuring a parameter of a substrate. The apparatus comprises an irradiation device configured to receive pump radiation, and to irradiate a metrology target on the substrate with the received radiation, thereby generating, through resonances, harmonic generated radiation. The apparatus further comprises a metrology sensor configured to detect intensities of at least two opposite radiation orders of the harmonic generated radiation diffracted by the metrology target. The apparatus further comprises one or more processors and a non-transitory storage medium storing instructions, that, when executed, configure the system to perform a method as described above.

According to another aspect of the current disclosure there is provided a metrology tool comprising an apparatus as described above.

According to another aspect of the current disclosure there is provided an inspection tool comprising an apparatus as described above.

According to another aspect of the current disclosure there is provided a lithographic apparatus comprising an apparatus as described above.

According to another aspect of the current disclosure there is provided a litho cell comprising an apparatus as described above.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figure 4 depicts a schematic overview of a scatterometry apparatus used as a metrology device, which may comprise a dark field digital holographic microscope according to embodiments of the invention;
Figure 5 comprises (a) a schematic diagram of a dark field scatterometer for use in measuring targets using a first pair of illumination apertures, (b) a detail of diffraction spectrum of a target grating for a given direction of illumination, (c) a second pair of illumination apertures providing further illumination modes in using the scatterometer for diffraction based overlay measurements and (d) a third pair of illumination apertures combining the first and second pair of apertures;
Figure 6 depicts a flowchart of steps in a method for measuring a parameter on a susbtrate;
Figure 7 depicts a flowchart of steps in a method for measuring a parameter on a substrate;
Figure 8 depicts a schematic representation of a meta-atom for a metasurface;
Figure 9 depicts a schematic representation of a measurement setup for determining an asymmetry of a meta-atom;
Figure 10 depicts a schematic representation of a measurement setup for determining a peak wavelength of generated harmonic radiation; and
Figure 11 depicts a schematic representation of an apparatus for measuring a parameter on a substrate.

### DETAILED DESCRIPTION

Before describing embodiments of the invention in detail, it is instructive to present an example environment in which embodiments of the present invention may be implemented.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

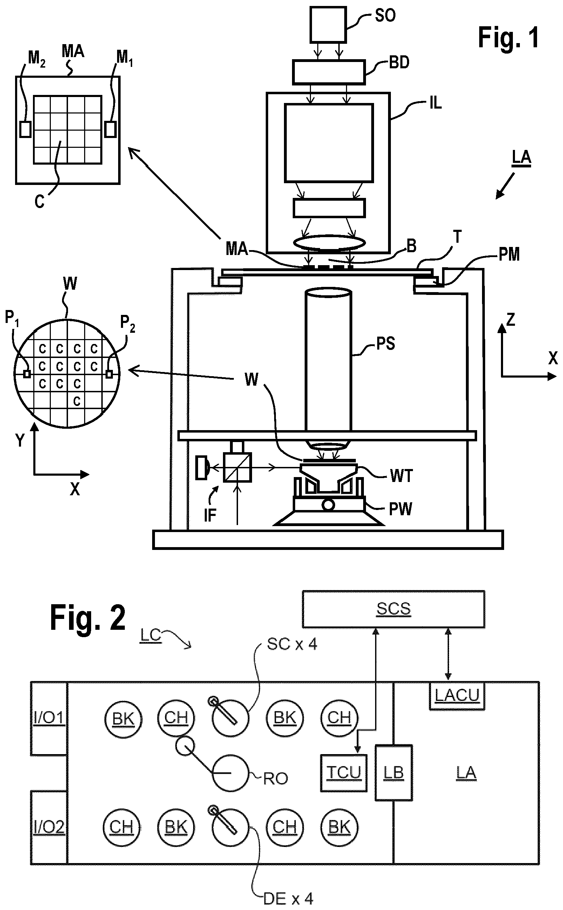

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and linewidth of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

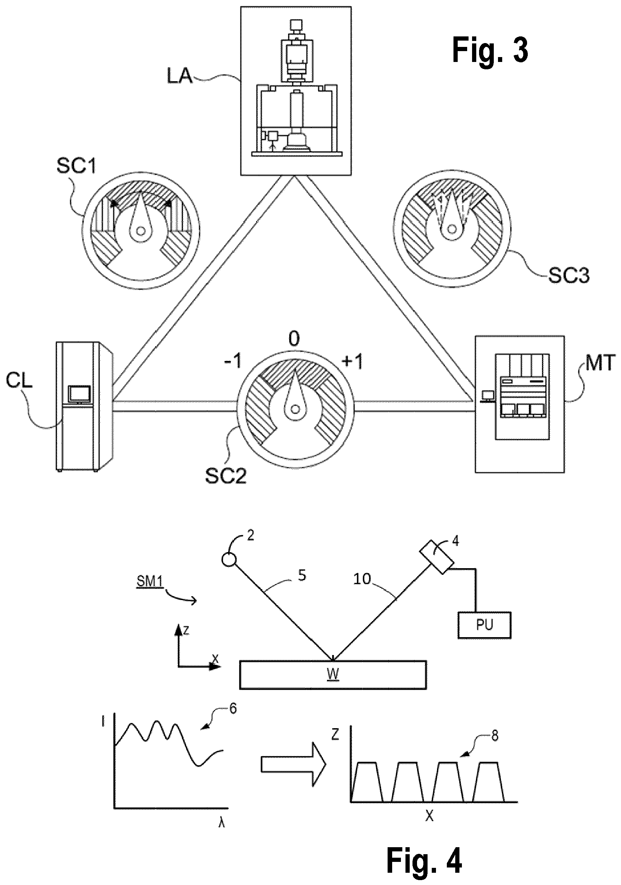

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

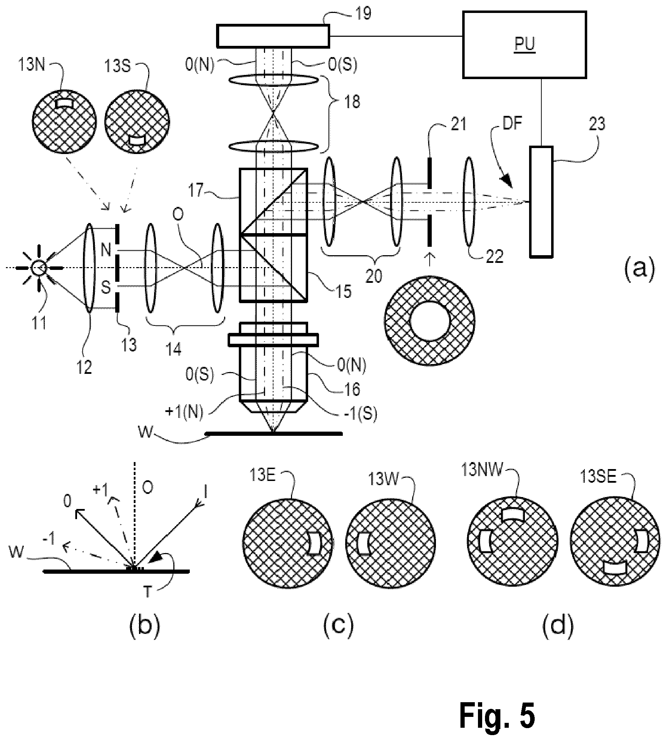

Another type of metrology apparatus is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 5) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

A light source for metrology applications usable for concepts disclosed herein may comprise any broadband source and a color selection arrangement to select one or more colors from the broadband output. By way of an example, the radiation source may be based on a hollow core or solid core fiber such as a hollow core photonic crystal fiber (HC-PCF) or solid core photonic crystal fiber (SC-PCF). For example, in the case of a HC-PCF, the hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. This is only one example of a broadband light source technology usable in methods and apparatuses disclosed herein, and other suitable technologies may instead be employed.

When using metrology sensors, including those described above and/or other types of metrology sensors (e.g., alignment sensors, levelling sensors), it is often desirable to control the illumination spectrum, e.g., to switch the illumination between different wavelengths (colors) and/or wavefront profiles.

Radiation, such as second, third, or high (including fourth, fifth, sixth, ....) harmonic radiation described above, may be used for measurements in a metrology tool MT. The metrology tool MT may use harmonic radiation to perform measurements on a substrate exposed by a lithographic apparatus. The measurements may be for determining one or more parameters of a structure on the substrate. Using radiation at shorter wavelengths, for example at EUV, HXR and/or SXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, HXR and/or SXR radiation, may also penetrate deeper into a material such as a patterned substrate, meaning that metrology of deeper layers on the substrate is possible. These deeper layers may not be accessible by radiation with longer wavelengths.

For some measurements related to lithography, for example critical dimension measurements, longer wavelength radiation may not be suitable. Current measurement techniques for measuring critical dimensions may rely on alternatives, such as scanning electron microscopes (SEMs). However, SEMs are slow, and therefore optical methods may be desirable. To determine systematic aberrations in patterning, linear optical scattering techniques may be used. Gratings and targets patterned on the substrate may be used. These gratings typically have larger dimensions than the structures patterned onto the substrate, comparable to the wavelengths of the measurement radiation, which may cause incorrect measurement of the structures. One way to reduce target size is therefore to reduce the wavelength of radiation used for the measurement. This may be achieved by generating shorter wavelength radiation using nonlinear processes, such as for example harmonic generation. Using nonlinear optical signals may enable a reduction of the feature size of metrology targets because of (A) the smaller wavelengths of the generated harmonics, and (B) the fact that a nonlinear local generation mechanism may be sensitive to high algebraic powers of the local electric field. This may enlarge the sensitivity to changes in the strongly localized fields that can be obtained inside the particles and/or in narrow gaps between suitably designed optical scattering objects. Provided herein are improved methods for measuring lithographic structures.

When generating harmonic radiation orders using meta-atoms, nonlinear metasurfaces may be considered. A metasurface may comprise a two-dimensional or a three-dimensional structure consisting of a plurality of unit-cells. Nonlinear metasurfaces can be used to produce different kinds of resonances to increase harmonic conversion efficiency. This may be of interest when looking for ways to obtain shorter wavelength radiation for metrology applications. One type of resonance is a quasi-BIC (quasi-Bound State in the Continuum) resonance. Quasi-BIC resonances may typically rely on sub-diffractive periodic lattices, in which very sharp spectral features (e.g. Fano-lines) may be induced in reflection and/or transmission. Such quasi-BIC resonances may be induced by introducing nanometer-scale asymmetries in the unit cell of a meta-surface.

It has been shown (e.g. by K. Koshelev *et al, "Asymmetric Metasurfaces with High-Q Resonances Governed by Bound States in the Continuum",* Phys, Rev Lett, 2018) that asymmetric structures in metasurfaces can have higher harmonic generation efficiency. The properties of the linear resonance response and of the harmonic generation efficiency may be researched as a function of asymmetry and wavelength.

Presented herein are systems and methods to use nonlinearly generated radiation from asymmetric metasurfaces for lithographic measurements.

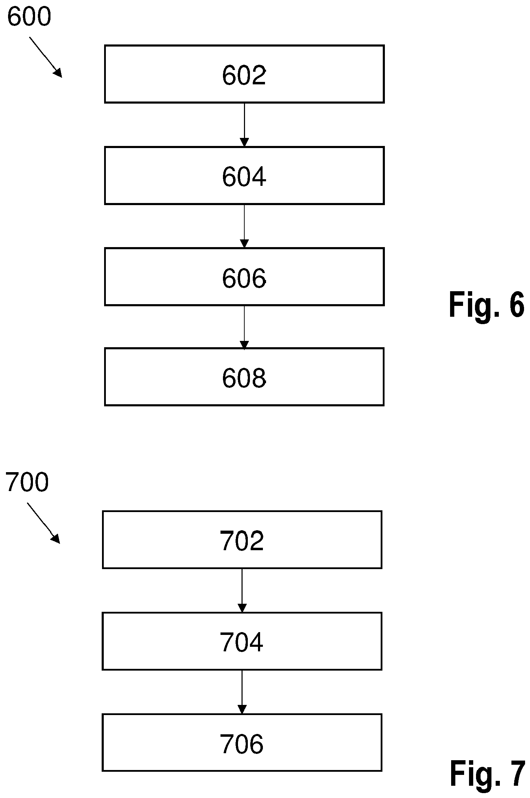

Figure 6 depicts a flowchart of a method 600 for measuring a parameter of a substrate. The substrate may be a lithographically patterned substrate. In step 602, pump radiation is received. A metrology target on the substrate is irradiated 604 with the received radiation, thereby generating, through resonances, harmonic generated radiation. Using a metrology sensor, intensities are detected 606 of at least two opposite radiation orders of the harmonic generated radiation diffracted by the metrology target. The parameter of the substrate is determined 608 based on the intensities of the at least two opposite radiation orders and a peak wavelength of the harmonic generated radiation. Whilst being described here as a parameter of the substrate, the parameter may also be described as a parameter of the metrology target of the substrate. A peak wavelength of the harmonic generated radiation is an example of an indication of the spectrally-dependent harmonic generation efficiency. Alternatively and/or additionally, other indications of the spectrally-dependent harmonic generation efficiency may be used.

An advantage of the method as described in relation to figure 6 is that the metrology target is able to generate harmonic radiation through resonances. This harmonic generated radiation is then diffracted by the metrology target. Both the peak wavelength of the harmonic generated radiation and the properties of the diffracted orders are used to analyze characteristics of the metrology target, and based thereon the parameter of the substrate. An important advantage of the current disclosure is therefore that the harmonic generated radiation is not provided to the metrology setup and/or the metrology target, but instead the harmonic radiation is generated at the metrology target itself.

The harmonic generated radiation may comprise one or more harmonic generated radiation order. Different harmonic generated radiation orders may have different wavelengths, with higher orders having shorter wavelengths. Typically, one of the harmonic generated radiation orders will have a higher intensity than the other harmonic radiation orders. If the intensity of one harmonic radiation order is significantly higher than the other harmonic radiation orders, such that its effects are dominant over the effects of other harmonic radiation orders, this harmonic radiation order may be referred to as the harmonic radiation order. The wavelength of the dominant harmonic radiation order may be referred to as the harmonic wavelength.

As described above, the metrology target may comprise a meta-structure. The meta-structure may be a meta-surface. The metasurface may comprise a plurality of unit cells, also referred to as meta-atoms. The unit cells may comprise one or more asymmetries that are smaller in size than at least one wavelength of the harmonic generated radiation.

The meta-structure may comprise a plurality of meta-atoms with a periodicity that is larger than the wavelength of the harmonic generated radiation. Each meta-atom may comprise one or more features with a first dimension that is smaller than at least one wavelength of the harmonic generated radiation. The first dimension may be referred to as a width w.

The meta-atoms may be organized in a periodic pattern. In some instances, the meta-structure may comprise a plurality of meta-atoms which are arranged in a non-periodic pattern. The non-periodic pattern may have a well-defined structure factor. The non-periodic pattern may for example be quasiperiodic, or deterministic aperiodic.

A meta-atom may also be referred to as a unit cell of the meta-structure. The meta-atoms may be arranged in a two-dimensional grid on the meta-structure. The periodicity of the meta-atom may be larger than the harmonic wavelength in order to have diffraction. A meta-atom may comprise one or more features. The features may also be referred to as building blocks. At least one dimension of the features, the first dimension, (e.g. a width w of the features) may be smaller than the harmonic wavelength.

A meta-atom may comprise a plurality of building blocks, in which different building blocks have a different size along at least one dimension. The dimension along which the building blocks differ in size may be first dimension. The first dimension of a first building block may have a size w in a range from 150 nm to 250 nm. A second building block may have a first dimension with a size that is in a range from 75% to 100% of the size of the first dimension of the first building block. The difference in size of the first dimension of the blocks may be noted as Δw, and may be in a range from 0 nm to 65 nm.

Generally, for pump radiation with a wavelength of λ, the size of a meta-atom may be in a range from λ/5 - λ/3, approximately. Within the meta-atom there may be a plurality of building blocks. Each building block may have a long dimension (e.g. a length) and a short dimension (e.g. a width). In one instance, the short dimension/width may be in a range from ¼ to ½ of the meta-atom size. This may equate to a size in a range from λ/20 to λ/6, approximately. This range may be used as a guideline range for size of building blocks of meta-atoms. Following such an example, for pump radiation with a wavelength of 1500 nm, this may enable meta-atoms in which building blocks have a width in a range from 100 nm to 300 nm. This shows that the range of the suitable dimensions of the building blocks may strongly depend on the wavelength of the pump radiation. Smaller sizes for width w may be possible for implementations where resonance with a harmonic wavelength instead. For example, for a resonance of the nth harmonic, the estimate for suitable width w may reduce by a factor n, for the nth harmonic.

The meta-structure may comprise a grating. The grating may comprise alternating grating lines having different widths. The meta-atom may comprise, or substantially be, a plurality of grating lines. The building blocks may comprise, or substantially be, grating lines. Grating lines may also be referred to as blocks. The blocks may have an elongate dimension (e.g. a length L), and a width w. Each block/grating line may have substantially the same length L. The width w may differ between grating lines. The difference in width w may be referred to as Δw. The width of the grating lines may be the dimension that is smaller than the harmonic wavelength. The length of the grating lines may be larger or shorter than, or substantially the same as the harmonic wavelength. Grating lines may alternate between a first grating line having a first width and a second grating line having a second width. The second width may be smaller than the first width. The first and second width may be interchangeable (e.g. such that a first grating line has a smaller width than the width of the second grating line).

The harmonic generated radiation may comprise a quasi-bound state in the continuum resonance. An advantage of using quasi-BIC resonances may be that they may be highly sensitive to metrology parameters in diffracted patterns. As a result, using quasi-BIC resonances may result in very sensitive measurements for determining a substrate parameter such as critical dimension. In some implementations, a single harmonic generated radiation order is measured (e.g. a third harmonic generated radiation order). In other implementations, multiple harmonic generated radiation orders are measured (e.g. two or more of third, fifth, and seventh harmonic generated radiation orders). The measurement may include an intensity or power measurement. The measurement may also include a spectral measurement to determine a spread of wavelength(s) of the harmonic generated radiation. The order generated may depend, among other things, on the materials of the meta-structure and/or of the substrate. For example, silicon, with a symmetric material structure, may enable generation of odd harmonic radiation orders.

The opposite radiation orders measured may comprise a positive first +1 diffraction order and a negative first -1 diffraction order. Figure 7 depicts a flowchart for an example method of measurement. In step 702 an asymmetry parameter may be determined based on a difference in the intensities of the at least two opposite radiation orders. The asymmetry parameter may be an asymmetry parameter for a meta-atom of a meta-structure. The asymmetry parameter may for example α = Δw/w representing a difference in width between a first grating line and a second grating line divided by the width of the first grating line. A geometrical parameter, such as for example an absolute size, may be determined 704 for a meta-structure. The absolute size may be a width w of a first feature of a meta-atom, such as a first grating line of a grating. The geometrical parameter may be determined based on the peak wavelength of the harmonic generated radiation. This may be determined by measuring the peak wavelength of the harmonic generated radiation. The geometrical parameter may further be determined based on the asymmetry parameter. A parameter of the substrate be determined 706 based on the geometrical parameter The parameter of the substrate that is determined may be a critical dimension of the patterned substrate. Determining critical dimension of a patterned substrate based on a nonlinear optical output, specifically on non-zeroth order harmonic generated diffracted radiation, may be an advantage of the methods described herein. A further advantage may be that the methods described herein are faster than non-optical methods such as SEMs, frequently used to determine critical dimension.

The parameter of the substrate may be any property determined based on a three-dimensional grating profile. The parameter may include and/or be based on one or more of critical dimension, etched linewidth, sidewall angle, height, thickness, surface roughness, line edge, linewidth roughness, and/or radius of curvature of edges. The parameter may in some instances also include beam misalignment in the patterning process, for example resulting from beam aberrations.

The pump radiation used for irradiating the metrology target may comprise radiation with one or more wavelengths in a range from 400 nm to 2500 nm. The pump radiation may comprise one or more wavelengths from example in a range from 400 nm to 2500 nm, in a range from 1100 nm to 2500 nm, in a range from 1100 nm to 1700 nm, or in a range from 800 nm to 1200 nm. Depending on the materials used for the substrate and/or the meta-structure, the wavelength of the radiation used may be adapted. Depending on the wavelength of the radiation, different materials used for the substrate and/or the meta-structure on the surface may be suitable. For example, for wavelengths below 1100 nm, silicon may become absorptive for the fundamental wavelength. This may result in loss of efficiency, and may result in damage to the substrate, including the metrology target (i.e. the meta-structure). A material such as for example Si₃N₄ has low absorption in the visible wavelength range, and may therefore be more suitable for pump wavelengths in the visible part of the spectrum (e.g. 400 - 800 nm). Dielectric materials and metals may be suitable to be used as a material for a substrate and/or meta-structure. Example dielectric may include silicon, germanium, Si₃N₄, (In)GaAs, and LiNbO₃. Example metals may be gold, and silver.

The harmonic generated radiation may comprise radiation with a wavelength in a range from 100 nm to 700 nm. The wavelength(s) of the harmonic generated radiation are dependent on the wavelength of the pump radiation. As a rough guide, if pump radiation is provided in a range from 400 nm to 2500 nm, then in theory, the longest third harmonic wavelength would be 2500 nm/3 ≈ 833 nm. The shortest third harmonic wavelength could be theoretically calculated from the shortest pump wavelength, e.g. 400 nm/3 ≈ 133 nm. If higher harmonics are considered, such as for example a fifth harmonic and a seventh harmonic, the shortest wavelength would in theory be calculated as the seventh harmonic wavelength for the shortest pump radiation wavelength, e.g. 400 nm / 7 ≈ 57 nm.

As discussed in more detail above, the dimensions of the periodicity of the meta-atoms should be larger than the harmonic wavelengths to be measured. Dimensions of individual features of meta-atoms, such as length, width, and height, may be (much) smaller than the harmonic wavelength. Furthermore, the first dimension (e.g. width w of a grating) of the building blocks that make up the meta-atoms should be smaller than the wavelength of the measured harmonic radiation.

In an example implementation, a high power pulsed laser at a fundamental frequency, for example having an infrared wavelength (1550 nm or 800 nm), may illuminate a metasurface. The metasurface may form the metrology target. The metasurface may consist of an array of unit-cells comprising high refractive index asymmetric meta-atoms. The meta-atoms may be formed from a silicon material. The meta-atoms may be placed on a low refractive index transparent substrate (glass/SiO2). The metasurface may support a quasi-BIC resonance, which spectrally is close to the fundamental wavelength. This resonance may be used to localize strong electromagnetic fields in the meta-atoms, and in the gaps between them. The strong fields may induce a nonlinear polarization, which may result in third harmonic generation.

When the pitch of the unit-cell (a center to center spacing between neighbouring meta-atoms, i.e. the repeat distance) is larger than the third harmonic wavelength but smaller than the fundamental pump wavelength, the metasurfaces may be non-diffractive for the pump wavelength, yet diffractive for the third harmonic radiation. From the difference in the intensities between the positive and negative third (or higher) harmonic diffraction orders (at a fixed wavelength), the asymmetry Δw (and optionally orientation of asymmetry) in the meta-atom can be deduced. Taking this asymmetry together with linear spectral measurements, or spectral measurements ascertaining the pump wavelength of maximum third harmonic generation efficiency, information about the absolute widths w of the particles in the unit cell can also be determined.

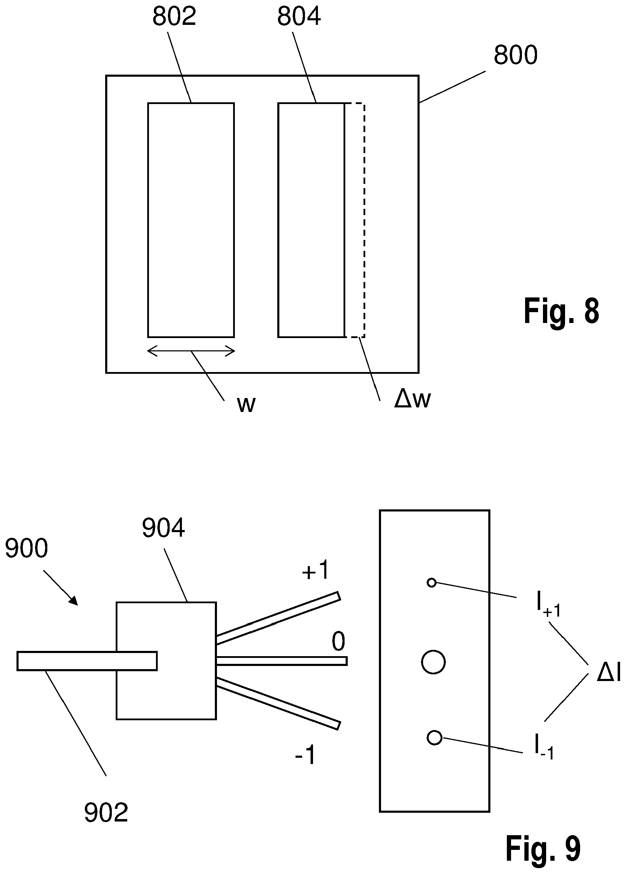

Figure 8 depicts a schematic representation of an example of a unit cell/meta-atom 800. The meta-atom may comprise a first grating line 802 and a second grating line 804. The width of the first and second grating lines may have a slight difference in width Δw, providing the asymmetry. The width of the first grating line may be referred to as the reference width w. The diffence in width may be governed by the asymmetry parameter α = Δw/w. A metrology target may in some instances comprise multiple metasurfaces with a deliberate different asymmetry.

The initial asymmetry in the unit-cell may be defined by the patterning input parameters. Aberrations in the patterning may cause slightly different asymmetries the the ones intended in the asymmetry design. These fabrication differences may be determined by comparing the nonlinear diffraction measurement to a library. From this, the real asymmetry in the unit-cell may be measured. For a given real asymmetry, the wavelength of the incident laser may be scanned. Linear transmission measurements, and/or determination of the wavelength at which the third harmonic generation peaks, may provide information on the absolute width w of the grating lines. The measurements described herein may therefore determine 2 metrological properties. A first property is a critical dimension parameter, which may be linked to, for example represented by Δw. The sensitivity of the nonlinearly generated light to change in Δw may be in the order of nanometers. A systematic asymmetry due to aberrations in patterning, may also be determined, as well as and orientation of this asymmetry.

Figure 9 depicts a schematic representation of a measurement setup 900 for determining an asymmetry of a meta-atom 904. In system 900 pump radiation 902 is incident onto a metasurface 904. Third harmonic radiation is generated, and diffracted by the metasurface. The positive +1 and negative -1 first diffraction orders and the zeroth order 0 of third harmonic generation are depicted. The intensities of the positive and negative diffraction orders are measured, shown schematically as I₊₁ and I₋₁. Due to the asymmetry in the meta-atoms, there is an asymmetry in the intensities I₊₁ and I₋₁ of the diffracted radiation, referred to as ΔI. By measuring the difference in diffracted intensity in the pair of diffraction orders and comparing it to a library of intensity values, the asymmetry of the meta-atom may be determined. Alternatively and/or additionally, the measured value could be compared to a calculation and/or simulation to determine the asymmetry of the meta-atom. The calculation and/or simulation may for example comprise a mathematical reconstruction model for the measurement setup. This may include a mathematical model for the generated radiation, as the measured signal may comprise radiation generated through optical nonlinear processes at the metrology target. The model may additionally and/or alternatively include transmitted, reflect, and/or scattered radiation from the metrology target. The figure is a schematic representation only, and does not limit the method and/or system to either reflection or transmission. The method is able to be performed on diffracted radiation in reflection and/or transmission.

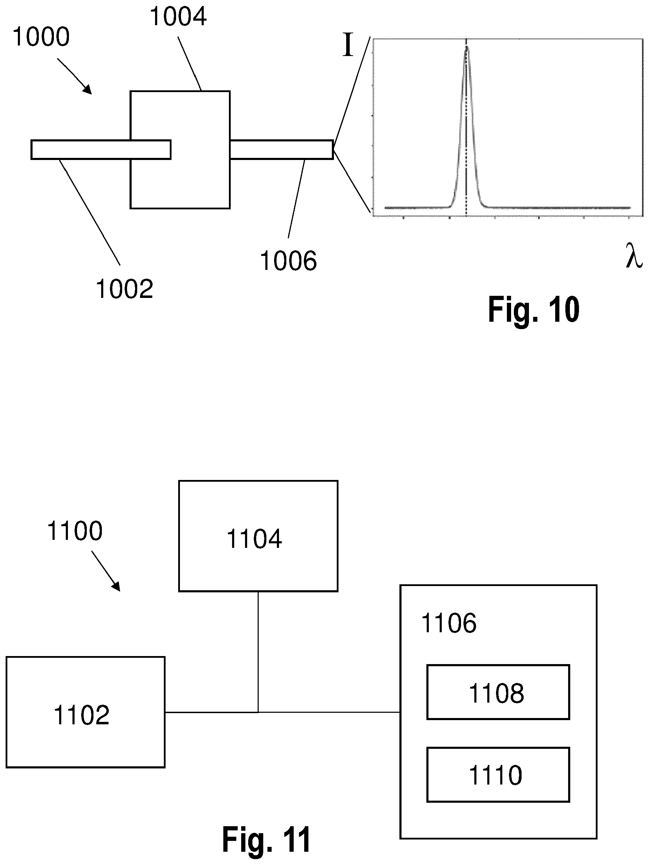

Figure 10 depicts a schematic representation of a measurement setup 1000 for determining a peak harmonic generated wavelength. Pump radiation 1002 is incident on metasurface 1004. Third harmonic radiation 1006 is generated at the metasurface, and measured by the system. Spectral analysis of the harmonic generated radiation is performed in order to determine the generated spectrum, including the peak generated wavelength. The spectral analysis may be performed on the zeroth diffracted order, and/or a higher diffraction order. Although described in relation to third harmonic generation, the systems and methods may also be suitable for other harmonic generated radiation orders.

Using resonant metasurfaces for determining a parameter may be advantageous due to nonlinear generation efficiency on those resonant metasurfaces. Furthermore, the nonlinearity may provide diffraction patterns with geometrical information encoded in a comparison of intensity in features at different angles. An advantage of using higher harmonics compared to the pump wavelength may be that a relative change in feature geometry of the meta-atoms compared to wavelength becomes larger for higher harmonics. Therefore, nonlinear metrology may be more sensitive to measure parameters than linear metrology. The use of shorter wavelengths means intrinsically smaller features may be accessed. Furthermore, the coherent transduction of geometry to radiation may scale with high algebraic powers of near field strength of the electromagnetic field at the metasurface.

The methods described herein may be performed by a metrology tool. The metrology tool may comprise and/or be connected to a source assembly for providing pump radiation. The pump radiation may be used to irradiate the metrology target on the substrate. The metrology tool may comprise one or more metrology sensors to detect intensities of diffracted harmonic generated radiation as described herein. One or more further sensors may be provided for detecting a peak wavelength of the harmonic generated radiation. The data measured by the one or more sensors may be provided to one or more processors of the metrology tool and/or connected to the metrology tool. The processor(s) may be hardware and/or software processors. The processor(s) may perform data processing steps are described herein. Specifically, the processor may process the measurement data in order to determine the parameter of the substrate.

The one or more sensors may include one or more photodetectors. A photodetector may be aimed to detect radiation at a specific angle. The one or more sensors may include a camera that is able to observe the harmonic wavelength. Such a photodetector or camera may be provided in a Fourier microscope setup. The one or more sensors may include a spectrometer (this may for example be a camera in combination with a diffractive grating). A spectrometer may be used for example for measuring linear transmission and/or the generated harmonic spectrum (e.g. for measuring peak wavelength).

Data may be collected in the form of one or more images, wherein an image may be understood to be a two-dimensional array of values. The one or more images may be processed to determine a single value. This single value may for example be a difference or ratio of harmonic diffraction intensities. The single value may alternatively and/or additionally be a peak wavelength of the harmonic generated radiation.

Figure 11 depicts an apparatus 1100 for determining a parameter of a substrate. The apparatus may be for executing a method as described in relation to figure 6. The apparatus comprises an irradiation device 1102 for receiving pump radiation. The irradiation device is further configured for irradiating a metrology target on the substrate with the received radiation. The substrate with the metrology target may be provided to the apparatus. The apparatus further comprises one or more metrology sensors 1104 for detecting intensities of radiation. Specifically, the one or more metrology sensors may be for measuring intensities of at least two opposite radiation order of harmonic generated radiation diffracted by the metrology target. The apparatus further comprises (or is connected to) a computing device 1106 comprising one or more processors 1108 and a non-transitory storage medium 1110. The one or more metrology sensors 1104 may be connected to the computing device for providing detected metrology data to the computing device. The metrology data may comprise the intensities of the opposite radiation orders determined by the sensors. The processor(s) 1108 may be configured to determine the parameter of the substrate based on the received intensities of the opposite radiation orders and data of a peak wavelength of the harmonic generated radiation. At least one of the metrology sensor(s) 1104 may be used to detect and output the data of a peak wavelength of the harmonic generated radiation.

The irradiation device may comprise a source. In other implementations, the irradiation device does not comprise a source, and instead comprises an assembly for receiving radiation from a source that is separate from the apparatus. The irradiation device may comprise one or more lenses and/or other optical elements for providing radiation to the metrology target of a substrate. The apparatus may have a holder or other receiving element for holding the substrate with metrology target. The metrology sensor may comprise any kind of sensor suitable for measuring intensity of radiation at the wavelength of the harmonic generated radiation. The computing device may be integrated in the apparatus, and/or may be coupled (wired or wirelessly) to the apparatus.

Figure 11 shows a simplified view of a computing device 1106, comprising one or more processors 1108 and non-transitory memory 1110. The one or more processors 1108 may comprise one or more hardware processors. The processors 1108 may comprise a central processing unit CPU. The functionality of the one or more processors described herein may be implemented in code (software) stored on a memory, and arranged for execution on the one or more processors. The storage media 1110 may be integrated in and/or separate from the processors 1108. Code stored in the memory may be configured so as when fetched from the memory to be executed on the one or more processors to perform operations in line with implementations of methods described herein. Alternatively and/or additionally, some or all of the functionality of the processors may be implemented in dedicated hardware circuitry, and/or configurable hardware circuitry (e.g. a field-programmable gate array FPGA).

Further embodiments are disclosed in the subsequent numbered clauses:
1. A method for measuring a parameter of a substrate, comprising
   receiving pump radiation;
   irradiating a metrology target on the substrate with the received radiation, thereby generating, through resonances, harmonic generated radiation;
   detecting, using a metrology sensor, intensities of at least two opposite radiation orders of the harmonic generated radiation diffracted by the metrology target; and
   determining the parameter of the substrate based on the intensities of the at least two opposite radiation orders and a peak wavelength of the harmonic generated radiation.
2. A method according to claim 1, wherein the metrology target comprises a meta-structure.
3. A method according to claim 2, wherein the meta-structure comprises a plurality of meta-atoms with a periodicity that is larger than the wavelength of the harmonic generated radiation, and wherein each meta-atom comprises one or more features with a first dimension that is smaller than at least one wavelength of the harmonic generated radiation.
4. A method according to any of claims 2-3, wherein the meta-structure comprises a grating, the grating comprising alternating grating lines having different widths.
5. A method according to claim 4, wherein the alternating grating lines comprise a first grating line having a first width and a second grating line having a second width, and wherein the second width is smaller than the first width.
6. A method according to any of the preceding claims, wherein the opposite radiation orders comprise positive and negative first diffraction orders.
7. A method according to any of the preceding claims, wherein the harmonic generated radiation comprises third harmonic radiation orders.
8. A method according to any of the preceding claims, wherein intensities of multiple harmonic generated radiation orders are measured.
9. A method according to claim 8, wherein the multiple harmonic generated radiation orders comprise at least two of the third, fifth, and seventh harmonic radiation orders.
10. A method according to any of the preceding claims, wherein generating the harmonic generated radiation comprises a quasi-bound state in the continuum resonance.
11. A method according to any of the preceding claims, wherein the parameter comprises critical dimension.
12. A method according to any of the preceding claims, when dependent on claim 2, further comprising:
   determining an asymmetry parameter based on a difference in the intensities of the at least two opposite radiation orders;
   determining a geometrical parameter based on the asymmetry parameter and the absolute size; and
   determining the parameter based on the geometrical parameter.
13. A method according to any of the preceding claims, wherein the pump radiation comprises radiation with a wavelength in a range from 400 nm to 2500 nm.
14. A method according to any of the preceding claims, wherein the harmonic generated radiation comprises radiation with a wavelength in a range from 100 nm to 700 nm.
15. An apparatus for measuring a parameter of a substrate, comprising:
   an irradiation device configured to receive pump radiation, and to irradiate a metrology target on the substrate with the received radiation, thereby generating, through resonances, harmonic generated radiation;
   a metrology sensor configured to detect intensities of at least two opposite radiation orders of the harmonic generated radiation diffracted by the metrology target; and
   one or more processors and a non-transitory storage medium storing instructions, that, when executed, configure the system to perform a method according to any of claims 1-14.
16. A metrology tool comprising an apparatus according to claim 15.
17. An inspection tool comprising an apparatus according to claim 15.
18. A lithographic apparatus comprising an apparatus according to claim 15.
19. A litho cell comprising an apparatus according to claim 15.

It should be appreciated that the term color is used throughout this text synonymously with wavelength or spectral component and the colors may include those outside the visible band (e.g., infrared or ultraviolet wavelengths).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A method for measuring a parameter of a substrate, comprising
receiving pump radiation;
irradiating a metrology target on the substrate with the received radiation, thereby generating, through resonances, harmonic generated radiation;
detecting, using a metrology sensor, intensities of at least two opposite radiation orders of the harmonic generated radiation diffracted by the metrology target; and
determining the parameter of the substrate based on the intensities of the at least two opposite radiation orders and a peak wavelength of the harmonic generated radiation.

2. A method according to claim 1, wherein the metrology target comprises a meta-structure.

3. A method according to claim 2, wherein the meta-structure comprises a plurality of meta-atoms with a periodicity that is larger than the wavelength of the harmonic generated radiation, and wherein each meta-atom comprises one or more features with a first dimension that is smaller than at least one wavelength of the harmonic generated radiation.

4. A method according to any of claims 2-3, wherein the meta-structure comprises a grating, the grating comprising alternating grating lines having different widths.

5. A method according to claim 4, wherein the alternating grating lines comprise a first grating line having a first width and a second grating line having a second width, and wherein the second width is smaller than the first width.

6. A method according to any of the preceding claims, wherein the opposite radiation orders comprise positive and negative first diffraction orders.

7. A method according to any of the preceding claims, wherein the harmonic generated radiation comprises third harmonic radiation orders.

8. A method according to any of the preceding claims, wherein intensities of multiple harmonic generated radiation orders are measured.

9. A method according to claim 8, wherein the multiple harmonic generated radiation orders comprise at least two of the third, fifth, and seventh harmonic radiation orders.

10. A method according to any of the preceding claims, wherein generating the harmonic generated radiation comprises a quasi-bound state in the continuum resonance.

11. A method according to any of the preceding claims, wherein the parameter comprises critical dimension.

12. A method according to any of the preceding claims, when dependent on claim 2, further comprising:
determining an asymmetry parameter based on a difference in the intensities of the at least two opposite radiation orders;
determining a geometrical parameter based on the asymmetry parameter and the absolute size; and
determining the parameter based on the geometrical parameter.

13. A method according to any of the preceding claims, wherein the pump radiation comprises radiation with a wavelength in a range from 400 nm to 2500 nm.

14. A method according to any of the preceding claims, wherein the harmonic generated radiation comprises radiation with a wavelength in a range from 100 nm to 700 nm.

15. An apparatus for measuring a parameter of a substrate, comprising:
an irradiation device configured to receive pump radiation, and to irradiate a metrology target on the substrate with the received radiation, thereby generating, through resonances, harmonic generated radiation;
a metrology sensor configured to detect intensities of at least two opposite radiation orders of the harmonic generated radiation diffracted by the metrology target; and
one or more processors and a non-transitory storage medium storing instructions, that, when executed, configure the system to perform a method according to any of claims 1-14.
